# EUROPEAN PATENT APPLICATION

(11) **EP 3 739 713 A1**
(43) Date of publication of application: **18.11.2020**
(21) Application number: 19175088.4
(22) Date of filing: 17.05.2019
(51) Int. Cl.: H02J 3/24, H01F 27/42, H02H 7/04, H02J 3/36

(54) **DC CURRENT DAMPER FOR A POWER GRID**

(71) Applicant: ABB Power Grids Switzerland AG, 5400 Baden (CH)
(72) Inventor: Ploetner, Christoph, 90592 Schwarzenbruck (DE)
(74) Representative: Epping - Hermann - Fischer

(57) **Abstract**

The present invention relates to a DC current damper for a medium voltage or high voltage transformer. The DC current damper comprises at least one pair of diodes. The two diodes in each pair of diodes are in an anti-parallel configuration. The at least one pair of diodes is configured to be installed in a power line (L1, L2, L3) of the power grid and to be operated at line potential.

## Description

### FIELD OF THE INVENTION

The present invention relates to a DC current damper for a power grid, for example for a power grid having DC and AC lines running in parallel, to a medium voltage or high voltage transformer having such a DC current damper, to a medium voltage or high voltage disconnector having such a DC current damper, to a medium voltage or high voltage switchgear having such a DC current damper, to an AC or AC/DC network having such a DC current damper and/or transformer and/or disconnector, and to a method of damping current with a DC current damper for a power grid.

### BACKGROUND

AC networks and power transformers are designed to operate with AC quantities. If for one or the other reason DC currents flow unintended in a superimposed manner through the AC power system and specifically pass through power transformers, this may frequently result in a number of adverse effects there, all caused by core saturation as a result of the DC current.

For instance, losses may increase with subsequent potential of thermal issues, but also the transformer noise level may increase dramatically.

There are several solutions available to block the DC current, when flowing symmetrically in all three phases and returning through the neutral point. If the DC current is however not equal in the three line phases, then blocking or compensating may require sophisticated and expensive solutions. A robust and simple solution is so far missing.

There is a need to address these issues.

### SUMMARY

Therefore, it would be advantageous to have an improved ability to mitigate the effects of small and medium DC currents in power grids, in medium voltage and high voltage transformers, reactors and other electrical equipment.

The object is solved with the subject matter of the independent claims, wherein further embodiments are incorporated in the dependent claims.

In a first aspect, there is provided a DC current damper for a power grid, such as an AC or AC/DC power grid, for example for a medium voltage or high voltage transformer, the DC current damper comprising at least one pair of diodes.

The two diodes in each pair of diodes are in an anti-parallel configuration. The at least one pair of diodes is configured to be placed in a power line of the power grid and to be operated at the potential of the line.

The regular AC current flow in the line is not adverily affected by the DC current damper.

The design of the DC current damper covers all loading conditons of the power line, including line loading during failure events.

Losses generated in the elements of the DC current damper due to permanent power line loading are moderate and suitably dissipated.

Losses generated in the elements of the DC current damper due to power line loading during failure events are suitably dissipated.

In this manner, the passive DC current damper blocks symmetric or unsymmetric DC current within a typical range needed without affecting the Power Grid operation adversily.

In an example, a current damper or "blocking device" is provided and is placed into the phase lines instead being connected to the neutral. The device is fully passive and comprises two legs each consisting of a number of series connected diodes. The anti-parallel connected legs are placed into each phase line allowing the AC currents to pass and the superimposed (unintended) DC currents, which may be driven by serval DC volts, to block. The number of diodes connected in series is determined by the DC voltage driving the DC current and is in principal not limited.

In an example, the DC current damper comprises a protection container, configured to electrically shield and thermally dissipate the heat of the at least one pair of diodes.

In an example, the power line is a phase line of a medium voltage or high voltage transformer.

The phase line of a medium voltage or high voltage transformer comprises all paths intended for AC current flow during normal power line loading.

In an example, the at least one pair of diodes is configured to block a DC voltage.

In an example the at least one pair of diodes is configured to reduce or eliminate a DC current.

In an example, the DC current damper is configured to block a DC current in the range 100 mA - a few Ampere.

In an example, the DC current damper is configured to block the DC current up to any one of: 2A; 3A; 5A; 7A; 10A.

In an example, the at least one pair of diodes comprises a plurality of pairs of diodes.

In an example, the plurality of pairs of diodes are cascaded.

In an example, the plurality of pairs of diodes are connected in series.

In an example, each pair of diodes is configured to have a threshold voltage of the order of 0.5-1.2V.

In an example, each pair of diodes is configured to have a threshold voltage of 0.8V.

The forward voltage (voltage drop) of a diode when conducting is about 0.7 V and a set of diodes in series has simply a voltage drop of "number of diodes x 0.7 V". As the driving DC voltages for the DC currents are not more than several volts for the purposes considered here, by connecting a number of diods in series the DC current can be blocked.

The DC current damper device may be configured to block symmetric and also non-symmetric DC currents (DC currents in phase lines having different magnitudes) and it may be installed into the individual phase lines. The location to place the DC current damper can in principal be anywhere in the power system, for instance inside or in the vicinity outside the transformer. It can be incorporated in disconnectors or anywhere suitable in the power line/system. Advantageou locations for the DC current damper inside transformers are right before forming neutral points because the phase potential of lines is usually low.

The cooling medium of the DC current damper can be air or another gas but can also be an insulating liquid such as transformer oil (if located inside the transformer).

The set of diodes or the complete DC current damper is operated at line potential and this requires proper insulation against earth potential. The DC current damper can be placed anywhere in the power line and can be specifically designed to be part of a power system component such as overhead or cable lines, power transformers, disconnectors or other components.

A shielding body having the line potential with the DC current damper mounted inside may be an advanteouges way to design the damping device. The damping device may also be configured as retro-fit solution for any existing power system. It may be used as a solution for the upcoming extension of the German (and other) power systems where DC and AC lines are running in parallel with the result of DC currents flowing with non-symmetric magnitude in the AC system.

In a second aspect, there is provided a medium voltage or high voltage transformer comprising a DC current damper according to the first aspect.

In a third aspect, there is provided a medium voltage or high voltage disconnector comprising a DC current damper according to the first aspect.

In a fourth aspect, there is provided a medium voltage or high voltage switchgear comprising a DC current damper according to the first aspect.

In a fith aspect, there is provided a medium voltage or high voltage switchgear comprising a medium voltage or high voltage transformer according to the second aspect.

In a sixth aspect, there is provided an AC or a mixed AC/DC network comprising a medium voltage or high voltage transformer according to the second aspect.

In a seventh aspect, there is provided a method of damping current with a DC current damper for a medium voltage or high voltage transformer. The DC current damper comprises at least one pair of diodes, wherein the two diodes in each pair of diodes are in an anti-parallel configuration. The method comprises connecting, i.e., placing, the at least one pair of diodes in a power line of the power grid and operating the DC current damper at line potential.

The above aspects and examples will become apparent from and be elucidated with reference to the embodiments described hereinafter.

### BRIEF DESCRIPTION OF THE DRAWINGS

Exemplary embodiments will be described in the following with reference to the following drawings:
Fig. 1 shows a schematic representation of a DC current damper; and
Fig. 2 shows a schematic representation of possible locations for DC current dampers integrated in a power grid.

### DETAILED DESCRIPTION OF EMBODIMENTS

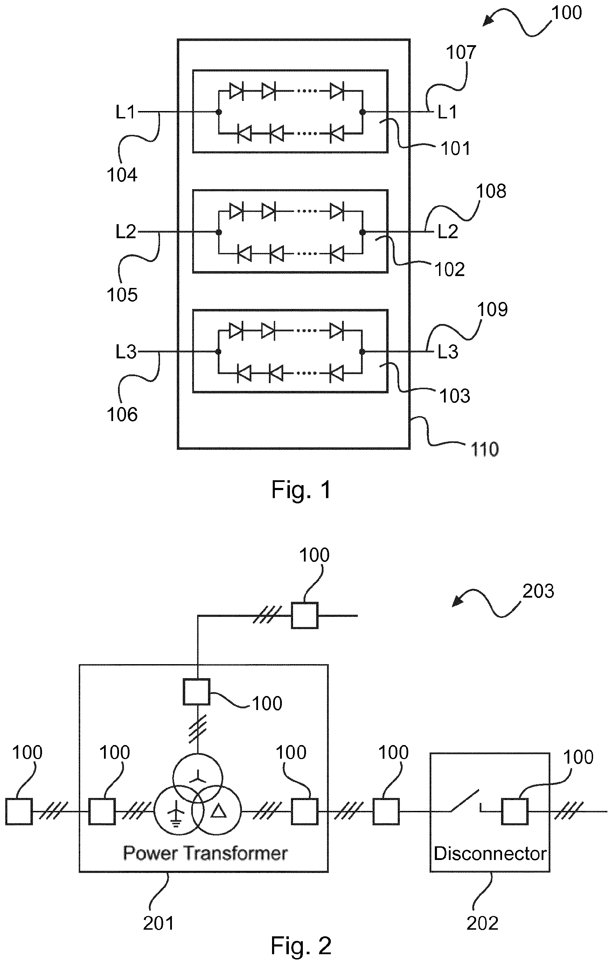

Fig. 1 shows a schematic representation of a DC current damper 100. Minor DC-bias may lead to a considerable increase of the noise level and to high reactive power consumption, as well as to a significant rise of no-load loss, in for example a transformer. Such a transformer can for example comprise a fluid insulated high voltage coil, with a closed tank for an insulation fluid and high voltage coils arranged therein, as well as dry-type high and medium voltage coils. Existing solutions to address this have a negative effect on the grounding system and/or are complex, costly and can only be used with new transformers specifically design for such solutions.

The DC damper 100 described here reduces the DC current and the consequential effects in medium voltage or high voltage equipment such as transformers and reactors.

In an example, the DC current damper comprises at least one pair of diodes 101. The two diodes in each pair of diodes are in an anti-parallel configuration. The at least one pair of diodes is configured to be placed, i.e., connected, in a power line L1, 104, 107 of the power grid and to be operated at line potential. Further sets of diodes 102, 103 are placed in the other power lines, L2, 105, 108, L3, 106, 109, of the power grid and also operated at line potential.

According to an example, the at least one pair of diodes is configured to block a DC voltage.

According to an example, the at least one pair of diodes is configured to reduce or eliminate a DC current.

According to an example, the DC current damper is configured to block a DC current in the range 100 mA - a few Amps.

According to an example, the DC current damper is configured to block the DC current up to any one of: 2A; 3A; 5A; 7A; 10A.

According to an example, the at least one pair of diodes comprises a plurality of pairs of diodes.

According to an example, the plurality of pairs of diodes are cascaded.

According to an example, the plurality of pairs of diodes are connected in series.

According to an example, each pair of diodes is configured to have a threshold voltage of the order of 0.5-1.2V.

According to an example, each pair of diodes is configured to have a threshold voltage of 0.8V.

Thus, it is clear that a medium voltage or high voltage transformer can comprise such a DC current damper as described above, and as discussed that DC damper finds utility in other medium voltage or high voltage equipment, such as a reactor. This then serves to provide a wider solution for equipment such as a medium voltage or high voltage switchgear that has such a DC current damper and/or a switchgear having a transformer with such a DC current damper.

Thus, a mechanism of damping current with a DC current damper for a medium voltage or high voltage transformer utilizes the DC current damper that comprises at least one pair of diodes, wherein the two diodes in each pair of diodes are in an anti-parallel configuration. The damping mechanism or method then involves placing and connecting the at least one pair of diodes in a power line of the power grid, and for example of the medium voltage or high voltage transformer. The DC current damper may be operated at line potential.

As discussed above, DC current may cause losses and increased noise in electrical equipment such as a medium voltage or high voltage transformer. Such DC currents are often in the range of a few 100 mA up to a few A. The DC current dampers 100 described here reduce or eliminate small DC currents, which are typical in AC transmission and distribution grids.

As shown in Fig. 1, the DC current damper 100 described here uses three arrangements of diodes 101, 102, 103, which are each connected, in series, to a power line L1, L2, L3, respectively, of a power transformer or other equipment, wherein those diodes are in anti-parallel connection.

The threshold voltage, Vₜₒ, of such a power diode in in the range of 0.8 V. This means that any voltage would be blocked by the diode. However, the diodes can be cascaded, in order to reach multiple times the threshold voltage, Vₜₒ, where now there can be n pairs of anti-parallel connected diodes. The effect is that a small U_{DC} will be blocked, and therefore no DC current will saturate the core up to the threshold voltage or a multiple thereof due to the cascaded diode pairs D₁-Dₙ.

Fig. 2 shows a schematic representation of possible locatons of the DC current dampers 100 integrated in a power grid 203, comprising a power transformer 201 and a disconnector 202.

It has to be noted that embodiments of the invention are described with reference to different subject matters. In particular, some embodiments are described with reference to method type claims whereas other embodiments are described with reference to the device type claims. However, a person skilled in the art will gather from the above and the following description that, unless otherwise notified, in addition to any combination of features belonging to one type of subject matter also any combination between features relating to different subject matters is considered to be disclosed with this application. However, all features can be combined providing synergetic effects that are more than the simple summation of the features.

While the invention has been illustrated and described in detail in the drawings and foregoing description, such illustration and description are to be considered illustrative or exemplary and not restrictive. The invention is not limited to the disclosed embodiments. Other variations to the disclosed embodiments can be understood and effected by those skilled in the art in practicing a claimed invention, from a study of the drawings, the disclosure, and the dependent claims.

In the claims, the word "comprising" does not exclude other elements or steps, and the indefinite article "a" or "an" does not exclude a plurality. The mere fact that certain measures are re-cited in mutually different dependent claims does not indicate that a combination of these measures cannot be used to advantage.

## Claims

1. A DC current damper (100) for a power grid (203), the DC current damper comprising:
at least one pair of diodes (101);
wherein the two diodes in each pair of diodes are in an anti-parallel configuration; and
wherein the at least one pair of diodes is configured to be placed in a power line (L1, L2, L3) of the power grid and to be operated at line potential.

2. DC current damper according to claim 1, further comprising a protection container (110) configured to electrically shield and thermally dissipate the heat of the at least one pair of diodes.

3. DC current damper according to claim 1 or 2, wherein the power line (L1, L2, L3) is a phase line of a medium voltage or high voltage transformer.

4. DC current damper according to one of the previous claims, wherein the at least one pair of diodes (101) is configured to block a DC voltage.

5. DC current damper according one of the previous claims, wherein the at least one pair of diodes (101) is configured to reduce or eliminate a DC current.

6. DC current damper according to one of the previous claims, wherein the DC current damper (100) is configured to block a DC current in the range 100 mA - a few A.

7. DC current damper according to one of the previous claims, wherein the at least one pair of diodes (101) comprises a plurality of pairs of diodes.

8. DC current damper according to claim 7, wherein the plurality of pairs of diodes are cascaded.

9. DC current damper according to one of claims 7 to 8, wherein the plurality of pairs of diodes are connected in series.

10. DC current damper according to one of the previous claims, wherein each pair of diodes (101) is configured to have a threshold voltage of the order of 0.5-1.2V.

11. A medium voltage or high voltage transformer (201) comprising a DC current damper (100) according to any of claims 1 to 10.

12. A medium voltage or high voltage disconnector (202) comprising a DC current damper (100) according to any of claims 1 to 10.

13. A medium voltage or high voltage switchgear comprising a medium voltage or high voltage transformer according to claim 12.

14. An AC network (203) comprising a DC current damper (100) according to one of claims 1 to 10.

15. A method of damping current with a DC current damper (100) for a power grid (203), the DC current damper comprising at least one pair of diodes (101), wherein the two diodes in each pair of diodes are in an anti-parallel configuration; and wherein the method comprises placing the at least one pair of diodes in a power line (L1, L2, L3) of the power grid and operating the DC current damper at line potential.
